# EUROPEAN PATENT APPLICATION

(11) **EP 4 848 341 A1**
(43) Date of publication of application: **02.12.2026**
(21) Application number: 25771574.8
(22) Date of filing: 06.01.2025
(51) Int. Cl.: H01L 23/467, H02M 7/48, H05K 7/20

(54) **COOLING STRUCTURE OF MAIN CIRCUIT MODULE**

(30) Priority: 11.03.2024 JP 2024037061
(71) Applicant: IHI Corporation, Koto-ku Tokyo 135-8710 (JP)
(72) Inventor: YAMAGUCHI, Koji, Tokyo 135-8710 (JP)
(74) Representative: TBK
(86) International application number: PCT/JP2025/000038
(87) International publication number: WO 2025/191990

(57) **Abstract**

A cooling structure 100 for a main circuit module includes a main circuit module 10 having a functional element 40 and a heat dissipation part 30 thermally coupled to the functional element 40, and a base part 20 to which the main circuit module 10 is attached. The heat dissipation part 30 has a first heat dissipation part 31 disposed on one principal surface S1 side of the functional element 40, and a second heat dissipation part 33 disposed on an other principal surface S2 side different from the one principal surface S1 of the functional element 40. In a state in which the main circuit module 10 is attached to the base part 20, the first heat dissipation part 31 is a first air-cooling fin 32 housed in a cooling air flow path 21, and the second heat dissipation part 33 is a second air-cooling fin 35 housed in a cooling air flow path 61 different from the cooling air flow path 21, or a cover member 34 that is in thermal contact with the other principal surface S2 of the functional element 40 and is thermally coupled to the first heat dissipation part 31.

## Description

### Technical Field

The present disclosure relates to a cooling structure for a main circuit module.

### Background Art

Patent Literature 1 discloses a power unit in which an insulating substrate having a wiring pattern on which a switching chip, a diode chip, and the like are mounted is disposed on a water-cooled cooler.

### Citation List

### Patent Literature

[Patent Literature 1] Japanese Unexamined Patent Publication No. 2001-352767

### Summary of Invention

### Technical Problem

Conventionally, when attempting to downsize large-capacity power converters and the like, liquid cooling methods such as water cooling have been exclusively selected in order to obtain sufficient cooling performance. However, since liquid cooling methods require piping, pumps, tanks, and the like, there have been problems such as the impact on layout due to these components, increased weight, increased cost, and increased maintenance load.

The present disclosure describes a cooling structure for a main circuit module that enables functional elements to be configured as a main circuit module and efficiently cooled using an air cooling method.

### Solution to Problem

A cooling structure for a main circuit module according to an aspect of the present disclosure includes a main circuit module having a functional element and a heat dissipation part thermally coupled to the functional element, and a base part to which the main circuit module is attached, wherein the heat dissipation part has a first heat dissipation part disposed on one principal surface side of the functional element and a second heat dissipation part disposed on an other principal surface side different from the one principal surface of the functional element, and wherein in a state in which the main circuit module is attached to the base part, the first heat dissipation part is a first air-cooling fin housed in a first cooling air flow path of the base part, and the second heat dissipation part is a second air-cooling fin housed in a second cooling air flow path of the base part different from the first cooling air flow path, or a member that is in thermal contact with the other principal surface of the functional element and is thermally coupled to the first heat dissipation part.

### Advantageous Effects of Invention

According to some aspects of the present disclosure, it is possible to configure functional elements as a main circuit module and efficiently cool the functional elements using an air cooling method.

### Brief Description of Drawings

[FIG. 1] FIG. 1 is an exploded side view illustrating an example of a schematic configuration of a first example of a cooling structure for a main circuit module.
[FIG. 2] FIGS. 2(a) and 2(b) are schematic cross-sectional views illustrating a first example of a main circuit module.
[FIG. 3] FIGS. 3(a) and 3(b) are schematic cross-sectional views illustrating a second example of a main circuit module.
[FIG. 4] FIGS. 4(a), 4(b), and 4(c) are schematic cross-sectional views illustrating a third example of a main circuit module.
[FIG. 5] FIGS. 5(a) and 5(b) are schematic cross-sectional views illustrating a fourth example of a main circuit module.
[FIG. 6] FIGS. 6(a) and 6(b) are schematic cross-sectional views illustrating a fifth example of a main circuit module.
[FIG. 7] FIG. 7(a) is an exploded side view illustrating an example of a schematic configuration of a second example of a cooling structure for a main circuit module. FIG. 7(b) is an exploded side view illustrating a variation of the schematic configuration of the second example of the cooling structure for a main circuit module.
[FIG. 8] FIG. 8(a) is a side view illustrating an example of a schematic configuration of a third example of a cooling structure for a main circuit module. FIG. 8(b) is a side view illustrating a variation of the schematic configuration of the third example of the cooling structure for a main circuit module.
[FIG. 9] FIG. 9(a) is a side view illustrating an example of a schematic configuration of a fourth example of a cooling structure for a main circuit module. FIG. 9(b) is a side view illustrating a variation of the schematic configuration of the fourth example of the cooling structure for a main circuit module.
[FIG. 10] FIG. 10(a) is a partially exploded side view illustrating an example of a schematic configuration of a variation of the fourth example of FIG. 9(a). FIG. 10(b) is a side view illustrating an example of the schematic configuration of the variation of the fourth example of FIG. 9(a).
[FIG. 11] FIGS. 11(a) and 11(b) are plan views illustrating examples of arrangements of main circuit modules.
[FIG. 12] FIG. 12 is an exploded side view illustrating an example of a schematic configuration of a fifth example of a cooling structure for a main circuit module.
[FIG. 13] FIGS. 13(a) and 13(b) are schematic cross-sectional views illustrating examples of the main circuit module of FIG. 12.
[FIG. 14] FIG. 14(a) is an exploded side view illustrating an example of a variation of the schematic configuration of the fifth example of the cooling structure for a main circuit module. FIG. 14(b) is a schematic side view of the assembled state of FIG. 14(a).

### Description of Embodiments

A cooling structure for a main circuit module according to an aspect of the present disclosure includes a main circuit module having a functional element and a heat dissipation part thermally coupled to the functional element, and a base part to which the main circuit module is attached, wherein the heat dissipation part has a first heat dissipation part disposed on one principal surface side of the functional element and a second heat dissipation part disposed on an other principal surface side different from the one principal surface of the functional element, and wherein in a state in which the main circuit module is attached to the base part, the first heat dissipation part is a first air-cooling fin housed in a first cooling air flow path of the base part, and the second heat dissipation part is a second air-cooling fin housed in a second cooling air flow path of the base part different from the first cooling air flow path, or a member that is in thermal contact with the other principal surface of the functional element and is thermally coupled to the first heat dissipation part.

In this cooling structure for a main circuit module, not only the first heat dissipation part on the one principal surface side but also the second heat dissipation part on the other principal surface side is disposed on the functional element of the main circuit module. The heat of the functional element is transferred to the first air-cooling fin as the first heat dissipation part and to the second air-cooling fin as the second heat dissipation part, and the first air-cooling fin is air-cooled by the cooling air in the first cooling air flow path while the second air-cooling fin is air-cooled by the cooling air in the second cooling air flow path. Alternatively, the heat of the functional element is transferred to the first air-cooling fin serving as both the first heat dissipation part and the second heat dissipation part, and the first air-cooling fin is air-cooled by the cooling air in the first cooling air flow path. In this manner, the functional element of the main circuit module attached to the base part is efficiently air-cooled from the one principal surface and the other principal surface. Therefore, it is possible to configure the functional element as a main circuit module and efficiently cool the functional element using an air cooling method.

In some embodiments, the second heat dissipation part may be a cover member that is in thermal contact with the other principal surface of the functional element and is thermally coupled to the first heat dissipation part. According to this configuration, the functional element can be air-cooled from the other principal surface via the cover member.

In some embodiments, the first cooling air flow path and the second cooling air flow path may be parallel to each other. According to this configuration, it becomes easier to dispose the first air-cooling fin on the one principal surface side of the functional element and the second air-cooling fin on the other principal surface side of the functional element, compared to a case in which the first cooling air flow path and the second cooling air flow path are not parallel.

In some embodiments, one end of the first cooling air flow path and one end of the second cooling air flow path may be connected such that a flow direction of cooling air in the first cooling air flow path and a flow direction of cooling air in the second cooling air flow path are opposite to each other. According to this configuration, the inlet and outlet of the cooling air can be disposed on the same end side of the first cooling air flow path and the second cooling air flow path.

In some embodiments, the main circuit module may include a first module in which the functional element is a capacitor or a filter coil, and a second module in which the functional element is a power module having a heat generation amount larger than that of the first module, wherein in the first module, the first air-cooling fin is housed in the first cooling air flow path, or the second air-cooling fin is housed in the second cooling air flow path, and wherein in the second module, the first air-cooling fin is housed in the first cooling air flow path, and the second air-cooling fin is housed in the second cooling air flow path. According to this configuration, since the second module, which has a larger heat generation amount than the first module, is cooled by both the first air-cooling fin and the second air-cooling fin, the second module can be cooled efficiently.

In some embodiments, the second heat dissipation part may include a second air-cooling fin housed in a second cooling air flow path of the base part different from the first cooling air flow path, and an auxiliary member that is in thermal contact with the functional element or the first air-cooling fin and is thermally coupled to the second air-cooling fin. According to this configuration, the auxiliary member, which is in thermal contact with the functional element or the first air-cooling fin and is thermally coupled to the second air-cooling fin, can constitute a heat transfer path to the second air-cooling fin.

In some embodiments, the main circuit module may include a pair of functional elements and a pair of second heat dissipation parts provided on both sides of the first heat dissipation part so as to sandwich the first heat dissipation part. According to this configuration, two functional elements and two second heat dissipation parts can be efficiently arranged.

In some embodiments, the main circuit module may be detachably attached in a state of being inserted into a module hole formed in the base part. According to this configuration, replacement or specification change of the main circuit module with respect to one base part becomes easy.

The cooling structure for a main circuit module of the present disclosure will be described in detail below with reference to the accompanying drawings. Same reference signs will be given to the same elements in the description of the drawings, and redundant explanation will be omitted.

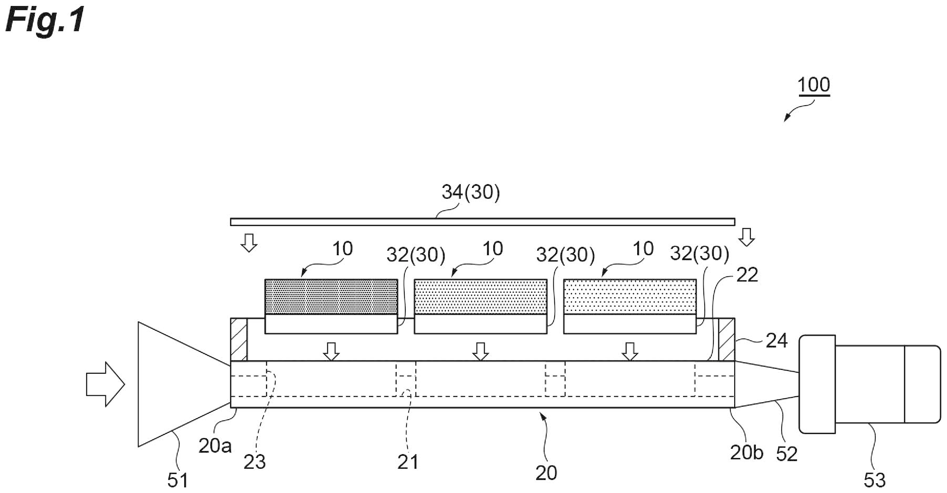

FIG. 1 is an exploded side view illustrating an example of a schematic configuration of a first example of a cooling structure for a main circuit module. As illustrated in FIG. 1, a cooling structure 100 for a main circuit module includes a main circuit module 10 in which functional elements constituting a main circuit are modularized. The main circuit is, for example, a power supply circuit of a power converter used in an electric blower, an electric compressor, or the like. The main circuit is constituted by functional elements such as power circuit elements, capacitors, filter coils, and reactors.

The cooling structure 100 for a main circuit module is a structure for cooling the main circuit module 10. In the cooling structure 100 for a main circuit module, unlike liquid cooling methods such as water cooling, a liquid cooling system such as liquid piping, pumps, and tanks is omitted. Since the cooling structure 100 for a main circuit module incorporates an air cooling system, it is possible to operate the main circuit by installing it at an installation location without additionally providing a separate liquid cooling system. According to the cooling structure 100 for a main circuit module, distributed use in which the main circuit is operated in a standalone manner at a plurality of installation locations is also easy. It should be noted that, although a liquid cooling system is not included in the present embodiment, it is also possible to use the cooling structure 100 for a main circuit module in combination with a liquid cooling system.

The cooling structure 100 for a main circuit module includes, for example, a base part 20 to which the main circuit module 10 is attached, an inlet duct 51 that introduces cooling air into the base part 20, and a blower 53 that leads cooling air out from the base part 20.

The base part 20 is a member that supports the main circuit module 10 and forms a cooling air flow path 21 (first cooling air flow path). The base part 20 is, for example, a base plate having a rectangular parallelepiped external appearance. As the material of the base plate, for example, a metal such as an aluminum alloy or a resin material such as plastic may be used.

In the example of FIG. 1, an inlet duct 51 is attached to one end 20a of the base part 20. A blower 53 is attached to the other end 20b of the base part 20 via an outlet duct 52.

Inside the base part 20, a cooling air flow path 21 that extends through from the one end 20a to the other end 20b is formed. The cooling air flow path 21 is, for example, a space extending along the longitudinal direction of the base part 20 inside the base part 20. The cooling air flow path 21 may be a space having a rectangular cross-section defined by being surrounded by an outer wall portion including the outer peripheral surface of the base part 20. The cooling air flow path 21 may be formed as a space inside the base part 20 by machining. The outer wall portion of the base part 20 may have a thickness that takes into account the support rigidity of the main circuit module 10.

In the cooling air flow path 21, when the blower 53 operates, cooling air is drawn into the one end 20a of the base part 20 via the inlet duct 51. The cooling air flows through the cooling air flow path 21 from the one end 20a toward the other end 20b of the base part 20. The cooling air is drawn from the other end 20b of the base part 20 into the blower 53 via the outlet duct 52, and flows out from the cooling air flow path 21. In the base part 20 of FIG. 1, the one end 20a is the upstream side in the flow direction of the cooling air, and the other end 20b is the downstream side in the flow direction of the cooling air.

The base part 20 includes a mounting surface 22 to which the main circuit module 10 is attached. In the example of FIG. 1, the mounting surface 22 is one of the surfaces of the outer wall portion of the base part 20. The mounting surface 22 is provided with a module hole 23 that extends to the cooling air flow path 21. The module hole 23 is a hole for attaching the main circuit module 10 to the base part 20. The module hole 23 is formed so as to open in the mounting surface 22 along a direction orthogonal to the longitudinal direction of the base part 20. The direction orthogonal to the longitudinal direction of the base part 20 corresponds to the normal direction of the mounting surface 22.

The module hole 23 opens in a shape (here, rectangular) corresponding to the outer peripheral shape of the main circuit module 10 in a plan view of the mounting surface 22. The module hole 23 may have an opening larger than the dimensions of the outer peripheral shape of the main circuit module 10, for example, taking into account the dimensional tolerance of the main circuit module 10.

The module holes 23 are arranged side by side along the longitudinal direction of the base part 20, for example, in accordance with the number of main circuit modules 10 (here, three). In the example of FIG. 1, the module holes 23 are separated by a part of the outer wall portion of the base part 20 between adjacent main circuit modules 10. The plurality of module holes 23 for the plurality of main circuit modules 10 are discontinuous with each other, except for the portion through which the cooling air flow path 21 passes. In the example of FIG. 1, one main circuit module 10 corresponds to each of the plurality of module holes 23.

The main circuit module 10 is, for example, detachably attached in a state of being inserted into the module hole 23 formed in the base part 20. The main circuit module 10 may have a claw that catches on the edge of the module hole 23 inside the base part 20 when inserted into the module hole 23. The main circuit module 10 may be detachably fastened to the base part 20 with bolts and nuts in a state of being inserted into the module hole 23. It should be noted that, in a state in which the main circuit module 10 is inserted into the module hole 23, the gap between the main circuit module 10 and the module hole 23 need not be sealed. That is, the coolant flowing through the cooling air flow path 21 may be able to flow into or out of the space accommodating the functional element through the gap of the module hole 23 around the main circuit module 10. It should be noted that "detachably attached" can be achieved using various existing methods other than fitting using claws and screwing using bolts, such as, for example, attachment utilizing elastic deformation or plastic deformation within a recoverable range, and attachment utilizing a pressing member installed so that its position can be changed. "Not detachably attached" means that it cannot be disassembled without cutting or destroying the fastened portion, as in the case of welding.

The main circuit module 10 is modularized so as to have, for example, a package structure in which one functional element and one heat dissipation part are integrated. The main circuit module 10 has a functional element and a heat dissipation part 30 thermally coupled to the functional element. The heat dissipation part 30 is a portion that serves as a heat transfer path for cooling the functional element or a portion for dissipating heat to the cooling air.

### [First Example of Main Circuit Module]

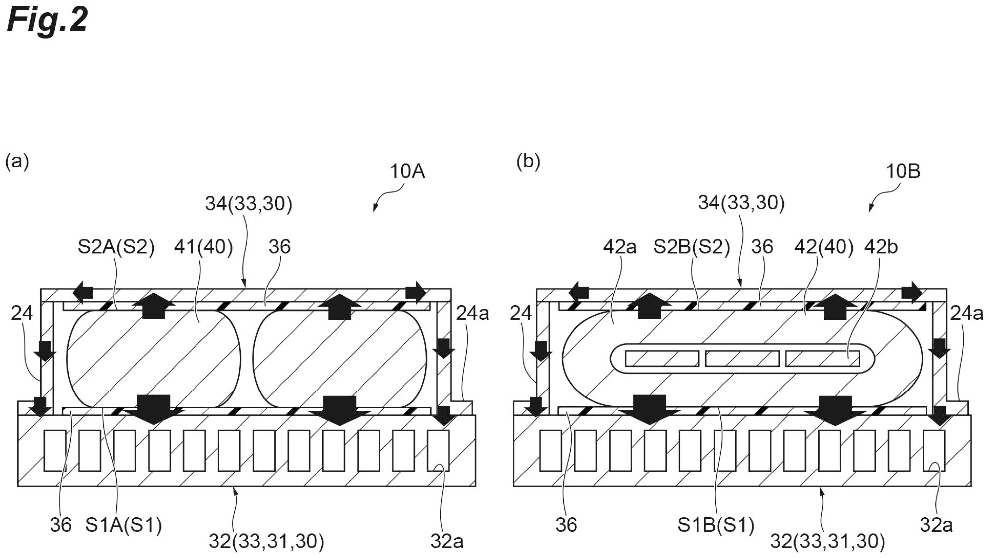

FIGS. 2(a) and 2(b) are schematic cross-sectional views illustrating a first example of a main circuit module. The heat dissipation part 30 has a first heat dissipation part 31 disposed on one principal surface S1 side of the functional element 40, and a second heat dissipation part 33 disposed on the other principal surface S2 side different from the one principal surface S1 of the functional element 40. In the examples of FIGS. 1, 2(a), and 2(b), the first heat dissipation part 31 is a first air-cooling fin 32 that is in thermal contact with the one principal surface S1 of the functional element 40. The second heat dissipation part 33 is a side wall part 24 (member) and a cover member 34 (member) that, in a state in which the main circuit module 10 is attached to the base part 20, are in thermal contact with the other principal surface S2 of the functional element 40 and are thermally coupled to the first heat dissipation part 31.

The one principal surface S1 of the functional element 40 is, in the examples of FIGS. 1, 2(a), and 2(b), a surface that is oriented in advance to face the mounting surface 22 side of the base part 20 when the main circuit module 10 is inserted into the module hole 23. The other principal surface S2 of the functional element 40 is, in the examples of FIGS. 1, 2(a), and 2(b), a surface that faces the side opposite to the mounting surface 22 of the base part 20 in advance when the main circuit module 10 is inserted into the module hole 23.

The first air-cooling fin 32 is housed in the cooling air flow path 21 of the base part 20 in a state in which the main circuit module 10 is attached to the base part 20. The first air-cooling fin 32 is made of metal such as aluminum or copper, for example. In the first air-cooling fin 32, a plurality of through holes 32a through which cooling air flows are defined. The cross-sectional shape of the plurality of through holes 32a is not particularly limited, but is, for example, a rectangular cross-section having the thickness direction of the first air-cooling fin 32 as the longitudinal direction. The plurality of through holes 32a are defined in the first air-cooling fin 32 so as to pass through along the extending direction of the cooling air flow path 21 in a state in which the main circuit module 10 is attached to the base part 20. The first air-cooling fin 32 may be attached to the one principal surface S1 of the functional element via a bonding agent 36 such as solder, for example.

As the bonding agent 36, for example, a TIM (Thermal Interface Material) such as a heat dissipation sheet can be used. The bonding agent 36 may have insulating properties as necessary.

The side wall part 24 is a side wall provided so as to partition a space accommodating the functional element 40. The side wall part 24 surrounds the periphery of the plurality of main circuit modules 10 attached to the base part 20 as viewed in the normal direction of the mounting surface 22 of the base part 20. The side wall part 24 has, for example, a rectangular frame shape as viewed in the normal direction of the mounting surface 22 of the base part 20. The outer edge of the space accommodating the functional element 40 has a rectangular shape along the longitudinal direction of the base part 20. It should be noted that, in FIG. 1, in order to illustrate the plurality of main circuit modules 10, the illustration of the front side of the side wall part 24 on the paper is omitted, and both the left and right sides of the side wall part 24 on the paper are illustrated as hatching indicating a cross-section. In FIGS. 2(a) and 2(b), the side wall part 24 may be attached to the base part 20 or the main circuit module 10 at a flange part 24a formed by bending along the mounting surface 22. The side wall part 24 is detachably attached to the base part 20 by, for example, fastening using bolts. It should be noted that the side wall part 24 may be attached non-detachably by, for example, adhesion or welding. For the side wall part 24, for example, a metal plate of aluminum or copper can be used.

The cover member 34 is a member that defines a space accommodating the functional element 40. The cover member 34 defines a space accommodating the functional element 40 by forming a box shape together with, for example, the side wall part 24 attached to the base part 20. The cover member 34 has an outer shape (here, rectangular) along the tip of the side wall part 24 as viewed in the normal direction of the mounting surface 22 of the base part 20. The tip of the side wall part 24 is the end of the side wall part 24 on the side opposite to the flange part 24a. The cover member 34 covers the plurality of main circuit modules 10 by being attached along the tip of the side wall part 24. The cover member 34 and the side wall part 24 are detachably attached to each other by, for example, fastening using bolts. It should be noted that the cover member 34 and the side wall part 24 may be attached to each other non-detachably by, for example, adhesion or welding. For the cover member 34, for example, a metal plate of aluminum or copper can be used. In the example of FIG. 1, the side wall part 24 and the cover member 34 serve as the second heat dissipation part 33 common to the plurality of main circuit modules 10. The cover member 34 may be provided as the second heat dissipation part 33, one for each of the plurality of main circuit modules 10. It should be noted that the side wall part 24 and the cover member 34 may be configured as an integrated member rather than separate members.

FIG. 2(a) illustrates a main circuit module 10A in a case in which the functional element 40 is a capacitor 41. In the main circuit module 10A, the first air-cooling fin 32 is attached to the one principal surface S1A of the capacitor 41 via the bonding agent 36. The cover member 34 is attached to the other principal surface S2A of the capacitor 41 via the bonding agent 36. The side wall part 24 is attached to the first air-cooling fin 32 at the flange part 24a. That is, the side wall part 24 and the cover member 34 are in thermal contact with the other principal surface S2A of the capacitor 41 and are thermally coupled to the first air-cooling fin 32. Therefore, as indicated by the thick arrows in FIG. 2(a), the heat of the capacitor 41 is transferred from the one principal surface S1A to the first air-cooling fin 32 as the first heat dissipation part 31. The heat of the capacitor 41 is transferred from the other principal surface S2A through the side wall part 24 and the cover member 34 to the first air-cooling fin 32 as the second heat dissipation part 33.

FIG. 2(b) illustrates a main circuit module 10B in a case in which the functional element 40 is a filter coil 42. In the main circuit module 10B, the first air-cooling fin 32 is attached to the one principal surface S1B of the filter coil 42 via the bonding agent 36. The cover member 34 is attached to the other principal surface S2B of the filter coil 42 via the bonding agent 36. In the filter coil 42, a core 42a (magnetic body) is wound around a conductor 42b (for example, a copper wire). The filter coil 42 has, for example, a flat cross-sectional shape as a whole. The one principal surface S1B may be one flat portion of the core 42a. The other principal surface S2B may be the other flat portion of the core 42a. The side wall part 24 is attached to the first air-cooling fin 32 at the flange part 24a. That is, the side wall part 24 and the cover member 34 are in thermal contact with the other principal surface S2B of the filter coil 42 and are thermally coupled to the first air-cooling fin 32. Therefore, as indicated by the thick arrows in FIG. 2(b), the heat of the filter coil 42 is transferred from the one principal surface S1B to the first air-cooling fin 32 as the first heat dissipation part 31. The heat of the filter coil 42 is transferred from the other principal surface S2B through the side wall part 24 and the cover member 34 to the first air-cooling fin 32 as the second heat dissipation part 33.

### [Second Example of Main Circuit Module]

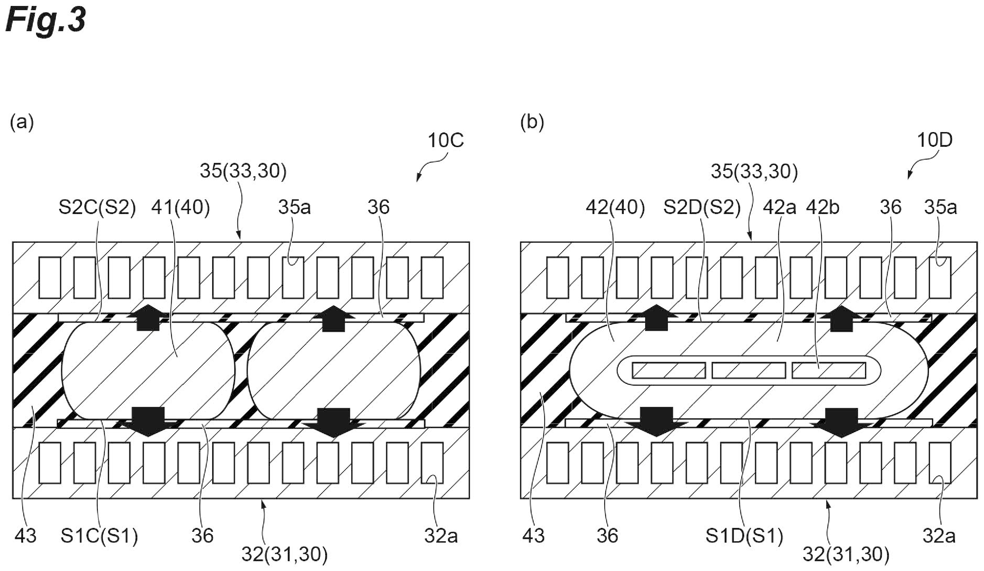

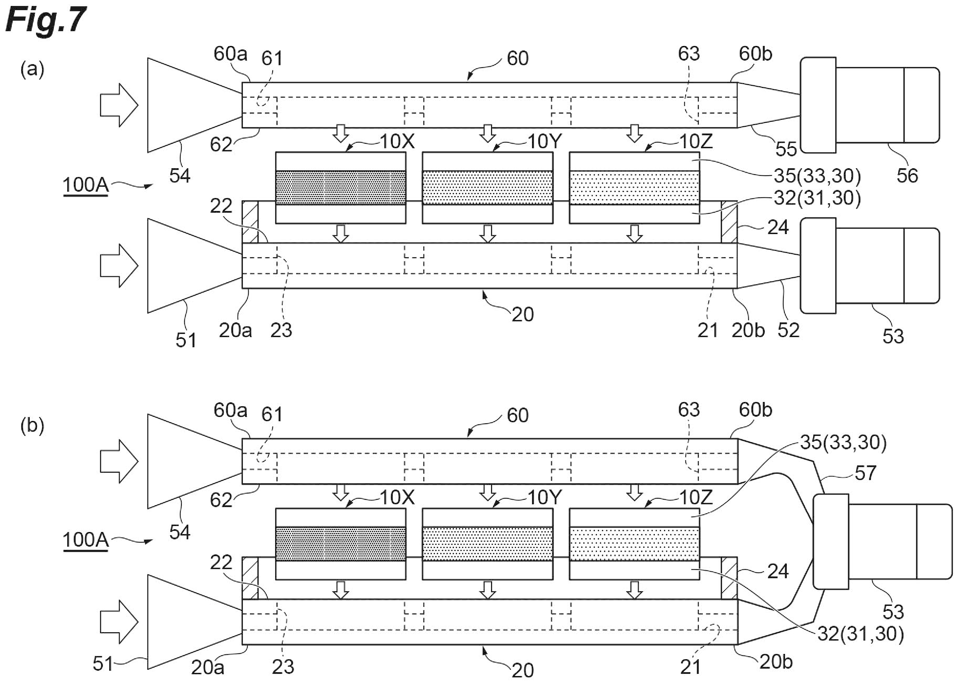

FIGS. 3(a) and 3(b) are schematic cross-sectional views illustrating a second example of a main circuit module. In the examples of FIGS. 3(a) and 3(b), the second heat dissipation part 33 is a second air-cooling fin 35 instead of the cover member 34. The second air-cooling fin 35 is configured similarly to the first air-cooling fin 32, for example, and has a plurality of through holes 35a. As will be described later, a main circuit module having the second air-cooling fin 35 as the second heat dissipation part 33 is attached to a base part 60 different from the base part 20. The second air-cooling fin 35 is housed in a cooling air flow path 61 (second cooling air flow path) of the base part 60 (see FIGS. 7(a) and 7(b)).

FIG. 3(a) illustrates a main circuit module 10C in a case in which the functional element 40 is a capacitor 41. In the main circuit module 10C, the first air-cooling fin 32 is attached to the one principal surface S1C of the capacitor 41 via the bonding agent 36. The second air-cooling fin 35 is attached to the other principal surface S2C of the capacitor 41 via the bonding agent 36. The periphery of the capacitor 41 sandwiched between the first air-cooling fin 32 and the second air-cooling fin 35 is filled with a sealing material 43 such as a resin having insulating properties, for example. Therefore, as indicated by the thick arrows in FIG. 3(a), the heat of the capacitor 41 is transferred from the one principal surface S1C to the first air-cooling fin 32 as the first heat dissipation part 31. The heat of the capacitor 41 is transferred from the other principal surface S2C to the second air-cooling fin 35 as the second heat dissipation part 33.

FIG. 3(b) illustrates a main circuit module 10D in a case in which the functional element 40 is a filter coil 42. In the main circuit module 10D, the first air-cooling fin 32 is attached to the one principal surface S1D of the filter coil 42 via the bonding agent 36. The second air-cooling fin 35 is attached to the other principal surface S2D of the filter coil 42 via the bonding agent 36. The periphery of the filter coil 42 sandwiched between the first air-cooling fin 32 and the second air-cooling fin 35 is filled with a sealing material 43 such as a resin having insulating properties, for example. Therefore, as indicated by the thick arrows in FIG. 3(b), the heat of the filter coil 42 is transferred from the one principal surface S1D to the first air-cooling fin 32 as the first heat dissipation part 31. The heat of the filter coil 42 is transferred from the other principal surface S2D to the second air-cooling fin 35 as the second heat dissipation part 33.

### [Third Example of Main Circuit Module]

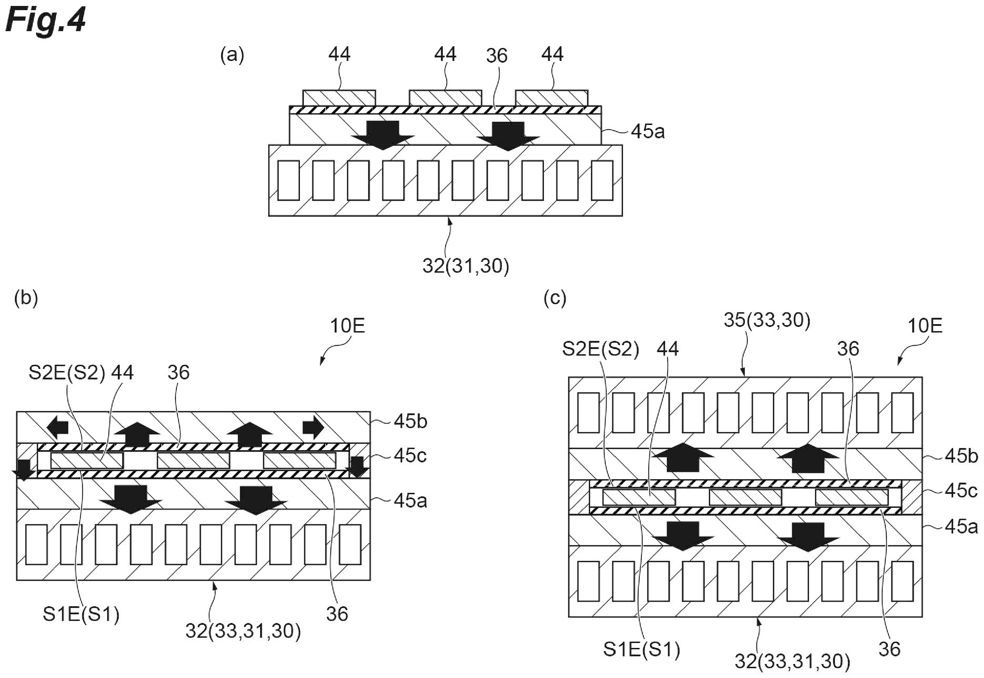

FIGS. 4(a) to 4(c) are schematic cross-sectional views illustrating a third example of a main circuit module. FIGS. 4(a) to 4(c) illustrate, as an example of the functional element 40, busbars 44 made of, for example, copper or aluminum. FIG. 4(a) illustrates a main circuit module 10E before the second heat dissipation part is provided. In the main circuit module 10E, a plurality of busbars 44 are arranged side by side. The plurality of busbars 44 are, for example, thermally coupled to the functional elements 40 of other main circuit modules. The plurality of busbars 44 may be electrically connected to the functional elements 40 of other main circuit modules.

In the main circuit module 10E, a heat conductive member 45a is disposed on the plurality of busbars 44 via the bonding agent 36. The heat conductive member 45a is, for example, a plate material of aluminum or the like. The heat conductive member 45a is disposed so as to be in contact with the first air-cooling fin 32. Therefore, the plurality of busbars 44 are thermally coupled to the first air-cooling fin 32 via the bonding agent 36 and the heat conductive member 45a.

FIG. 4(b) illustrates the main circuit module 10E provided with heat conductive members 45b and 45c (members) as the second heat dissipation part. In the main circuit module 10E of FIG. 4(b), the first air-cooling fin 32 is attached to the one principal surface S1E of the plurality of busbars 44 via the bonding agent 36 and the heat conductive member 45a. The heat conductive member 45b is attached to the other principal surface S2E of the plurality of busbars 44 via the bonding agent 36. The heat conductive member 45a and the heat conductive member 45b are connected by the heat conductive member 45c. That is, the heat conductive member 45b is in thermal contact with the other principal surface S2E of the busbars 44 and is thermally coupled to the first air-cooling fin 32. Therefore, as indicated by the thick arrows in FIG. 4(b), the heat of the plurality of busbars 44 is transferred from the one principal surface S1E to the first air-cooling fin 32 as the first heat dissipation part 31. The heat of the plurality of busbars 44 is transferred from the other principal surface S2E through the heat conductive members 45b and 45c to the first air-cooling fin 32 as the second heat dissipation part 33.

FIG. 4(c) illustrates the main circuit module 10E provided with the second air-cooling fin 35 in addition to the heat conductive members 45b and 45c as the second heat dissipation part 33. In the main circuit module 10E, the first air-cooling fin 32 is attached to the one principal surface S1E of the plurality of busbars 44 via the bonding agent 36 and the heat conductive member 45a. The heat conductive member 45b is attached to the other principal surface S2E of the plurality of busbars 44 via the bonding agent 36. In the main circuit module 10E of FIG. 4(c), the second air-cooling fin 35 is attached to the other principal surface S2E of the plurality of busbars 44 via the bonding agent 36 and the heat conductive member 45b. Therefore, as indicated by the thick arrows in FIG. 4(c), the heat of the plurality of busbars 44 is transferred from the one principal surface S1E to the first air-cooling fin 32 as the first heat dissipation part 31. The heat of the plurality of busbars 44 is transferred from the other principal surface S2E to the second air-cooling fin 35 as the second heat dissipation part 33.

### [Fourth Example of Main Circuit Module]

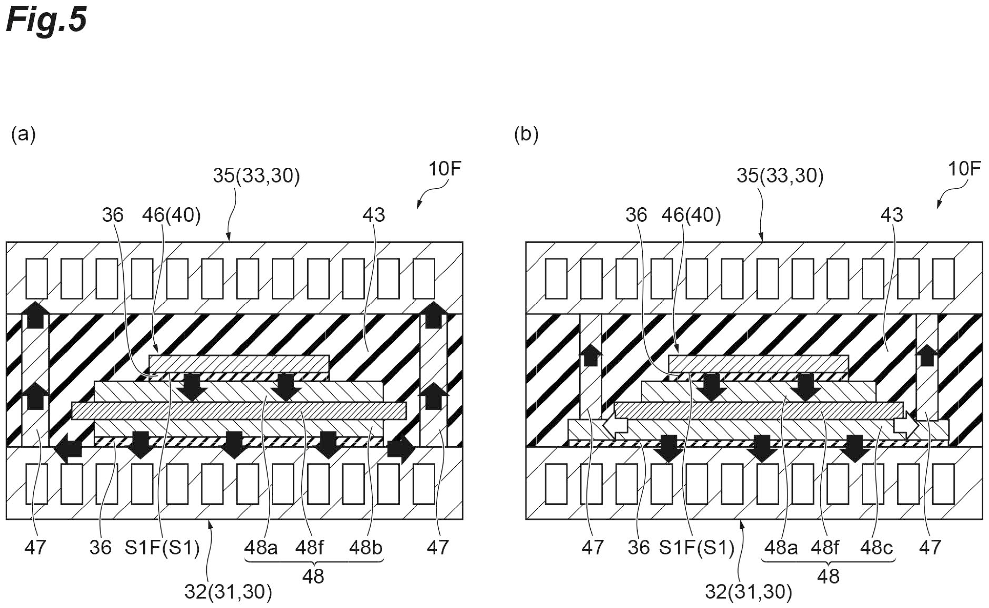

FIGS. 5(a) and 5(b) are schematic cross-sectional views illustrating a fourth example of a main circuit module. FIGS. 5(a) and 5(b) illustrate a main circuit module 10F having an auxiliary member 47 in a case in which the functional element 40 is a power circuit element 46. The power circuit element 46 is, for example, a power semiconductor element such as a MOSFET. The power circuit element 46 is provided on a substrate 48. The substrate 48 is a so-called DBC substrate. On the surface of the substrate 48, a plurality of wiring patterns, pads, lands, and the like are provided.

The substrate 48 has, for example, a conductive layer 48a, an insulating layer 48f, and a conductive layer 48b or a conductive layer 48c. The conductive layers 48a, 48b, and 48c are, for example, copper or aluminum. The insulating layer 48f is, for example, silicon nitride, aluminum nitride, resin, or the like. The rear surface of the power circuit element 46 corresponds to the one principal surface S1F of the power circuit element 46, and is in contact with the surface of the conductive layer 48a via the bonding agent 36. The rear surface of the conductive layer 48a is in contact with the surface of the insulating layer 48f. The rear surface of the insulating layer 48f is in contact with the surface of the conductive layer 48b or the conductive layer 48c. The rear surface of the conductive layer 48b or the conductive layer 48c is in contact with the surface of the first air-cooling fin 32 via the bonding agent 36.

In the main circuit module 10F, the second air-cooling fin 35 is attached at a distance from the power circuit element 46. The periphery of the power circuit element 46 sandwiched between the first air-cooling fin 32 and the second air-cooling fin 35 is filled with a sealing material 43 such as a resin having insulating properties, for example.

FIG. 5(a) illustrates the main circuit module 10F in which the auxiliary member 47 is in thermal contact with the first air-cooling fin 32. In the main circuit module 10F of FIG. 5(a), the auxiliary member 47 is in contact with the first air-cooling fin 32 and is thermally coupled to the second air-cooling fin 35. One end of the auxiliary member 47 is in contact with the surface of the first air-cooling fin 32. The other end of the auxiliary member 47 is in contact with the rear surface of the second air-cooling fin 35. The auxiliary member 47 may be, for example, a rod or plate material of copper or aluminum. The periphery of the auxiliary member 47 is filled with the sealing material 43. Therefore, as indicated by the thick arrows in FIG. 5(a), the heat of the power circuit element 46 is transferred from the one principal surface S1F to the first air-cooling fin 32 as the first heat dissipation part 31. A part of the heat of the power circuit element 46 transferred from the one principal surface S1F to the first air-cooling fin 32 is transferred through the auxiliary member 47 to the second air-cooling fin 35 as the second heat dissipation part 33.

FIG. 5(b) illustrates the main circuit module 10F in which the auxiliary member 47 is in thermal contact with the power circuit element 46. In the main circuit module 10F of FIG. 5(b), the auxiliary member 47 is in contact with the conductive layer 48c and is thermally coupled to the second air-cooling fin 35. The conductive layer 48c corresponds to the conductive layer 48b enlarged so as to be in contact with the auxiliary member 47. The conductive layer 48c is disposed in the same manner as the conductive layer 48b. The conductive layer 48a and the insulating layer 48f may be reduced so as not to be in contact with the auxiliary member 47. One end of the auxiliary member 47 is in contact with the surface of the conductive layer 48c. The other end of the auxiliary member 47 is in contact with the rear surface of the second air-cooling fin 35. The surface of the conductive layer 48c is the portion where the auxiliary member 47 is in thermal contact with the power circuit element 46. Therefore, as indicated by the thick arrows in FIG. 5(b), the heat of the power circuit element 46 is transferred from the one principal surface S1F to the first air-cooling fin 32 as the first heat dissipation part 31. The heat of the power circuit element 46 is transferred from the surface of the conductive layer 48c through the auxiliary member 47 to the second air-cooling fin 35 as the second heat dissipation part 33.

### [Fifth Example of Main Circuit Module]

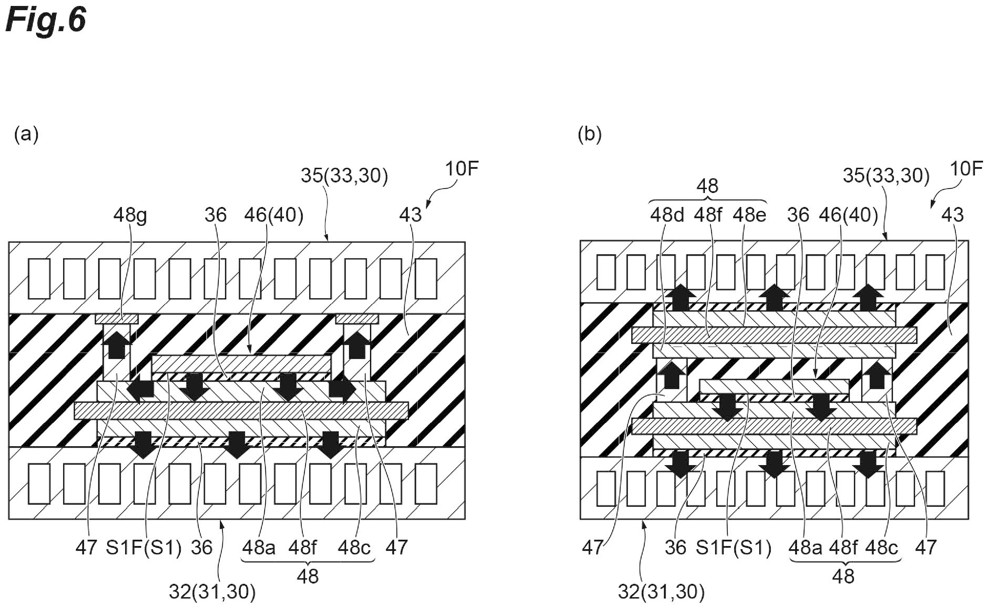

FIGS. 6(a) and 6(b) are schematic cross-sectional views illustrating a fifth example of a main circuit module. FIG. 6(a) illustrates another example of the main circuit module 10F in which the auxiliary member 47 is in thermal contact with the power circuit element 46. One end of the auxiliary member 47 is in contact with the surface of the conductive layer 48a instead of the surface of the conductive layer 48c. The other end of the auxiliary member 47 is in contact with the rear surface of the second air-cooling fin 35 via an insulating layer 48g. It should be noted that the insulating layer 48g is not essential. In this case, the surface of the conductive layer 48a is the portion where the auxiliary member 47 is in thermal contact with the power circuit element 46. Therefore, as indicated by the thick arrows in FIG. 6(a), the heat of the power circuit element 46 is transferred from the one principal surface S1F to the first air-cooling fin 32 as the first heat dissipation part 31. The heat of the power circuit element 46 is transferred from the surface of the conductive layer 48a through the auxiliary member 47 to the second air-cooling fin 35 as the second heat dissipation part 33.

FIG. 6(b) illustrates yet another example of the main circuit module 10F in which the auxiliary member 47 is in thermal contact with the power circuit element 46. The main circuit module 10F of FIG. 6(b) has an additional substrate 48 provided between the power circuit element 46 and the second air-cooling fin 35. The substrate 48 has, for example, a conductive layer 48d, an insulating layer 48f, and a conductive layer 48e. One end of the auxiliary member 47 is in contact with the surface of the conductive layer 48a. The other end of the auxiliary member 47 is in contact with the rear surface of the conductive layer 48d of the additional substrate 48 instead of the rear surface of the second air-cooling fin 35. Therefore, as indicated by the thick arrows in FIG. 6(b), the heat of the power circuit element 46 is transferred from the one principal surface S1F to the first air-cooling fin 32 as the first heat dissipation part 31. The heat of the power circuit element 46 is transferred from the surface of the conductive layer 48a through the auxiliary member 47 and the additional substrate 48 to the second air-cooling fin 35 as the second heat dissipation part 33.

FIG. 7(a) is an exploded side view illustrating an example of a schematic configuration of a second example of a cooling structure for a main circuit module. FIG. 7(b) is an exploded side view illustrating a variation of the schematic configuration of the second example of the cooling structure for a main circuit module. A cooling structure 100A for a main circuit module according to the second example differs from the cooling structure 100 for a main circuit module according to the first example in that it includes a base part 60 having a cooling air flow path 61 in which the second air-cooling fin 35 is housed.

The cooling structure 100A for a main circuit module can cool the main circuit modules 10C to 10F having the second air-cooling fin 35 illustrated in FIGS. 3(a) to 6(b). In the following description, main circuit modules to which any of the main circuit modules 10C to 10F can be applied are referred to representatively as main circuit modules 10X to 10Z.

The base part 60 is configured basically in the same manner as the base part 20. The base part 60 includes a mounting surface 62 to which the main circuit modules 10X to 10Z are attached. The base part 60 is formed with module holes 63 for attaching the second air-cooling fins 35 of the main circuit modules 10X to 10Z to the base part 60.

In the example of FIG. 7(a), the cooling air flow path 21 and the cooling air flow path 61 are parallel and independent of each other. An inlet duct 54 is attached to one end 60a of the base part 60. A blower 56 is attached to the other end 60b of the base part 60 via an outlet duct 55.

In the example of FIG. 7(b), the cooling air flow path 21 and the cooling air flow path 61 are parallel, and the blower 53 can be used in common. An inlet duct 54 is attached to one end 60a of the base part 60. The blower 53 is attached to the other end 60b of the base part 60 via an outlet duct 57. The blower 53 is attached to the other end 20b of the base part 20 via the outlet duct 57 instead of the outlet duct 52. The outlet duct 57 is a duct that connects the two cooling air flow paths 21 and 61 with one blower 53.

In the examples of FIGS. 7(a) and 7(b), in each of the main circuit modules 10X to 10Z, when the second air-cooling fin 35 is inserted into the module hole 63, the second air-cooling fin 35 is disposed in the cooling air flow path 61 such that the through holes 35a of the second air-cooling fin 35 are aligned along the extending direction of the cooling air flow path 61. In the cooling air flow path 21 and the cooling air flow path 61, cooling air flows independently in the same direction. Therefore, the first air-cooling fin 32 is cooled by the cooling air flowing through the cooling air flow path 21, and the second air-cooling fin 35 is cooled by the cooling air flowing through the cooling air flow path 61.

In such a flow of cooling air, in the examples of FIGS. 7(a) and 7(b), in all of the main circuit modules 10X to 10Z, the first air-cooling fin 32 is disposed in the cooling air flow path 21 and the second air-cooling fin 35 is disposed in the cooling air flow path 61. Therefore, the order of cooling, from the upstream side of the cooling air, is the first air-cooling fin 32 and the second air-cooling fin 35 of the main circuit module 10X, the first air-cooling fin 32 and the second air-cooling fin 35 of the main circuit module 10Y, and the first air-cooling fin 32 and the second air-cooling fin 35 of the main circuit module 10Z. The functional elements 40 included in the main circuit modules 10X to 10Z may be selected taking into account this order of cooling and the heat generation amount of the functional elements 40. For example, the power circuit element 46 may be included in the main circuit module 10X to prioritize cooling of the power circuit element 46.

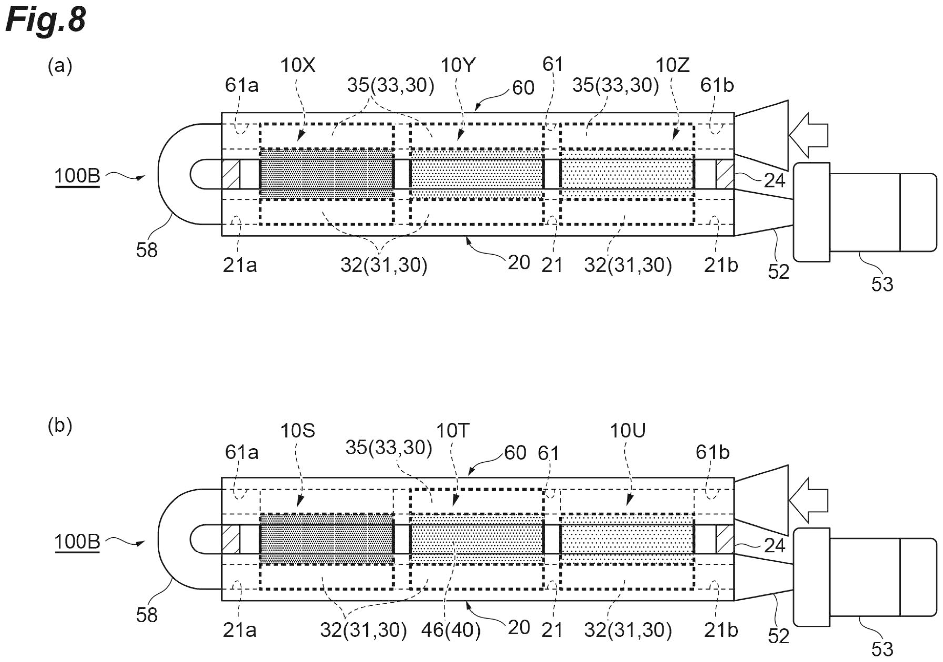

FIG. 8(a) is a side view illustrating an example of a schematic configuration of a third example of a cooling structure for a main circuit module. FIG. 8(b) is a side view illustrating a variation of the schematic configuration of the third example of the cooling structure for a main circuit module. A cooling structure 100B for a main circuit module according to the third example differs from the cooling structure 100A for a main circuit module according to the second example of the examples of FIGS. 7(a) and 7(b) in that the cooling air flow path 21 and the cooling air flow path 61 are parallel but not independent of each other.

One end 21a of the cooling air flow path 21 and one end 61a of the cooling air flow path 61 are connected by a U-shaped pipe 58 such that the flow direction of the cooling air in the cooling air flow path 21 and the flow direction of the cooling air in the cooling air flow path 61 are opposite to each other. Therefore, in the cooling air flow path 21 and the cooling air flow path 61, the cooling air first flows in from the other end 61b of the cooling air flow path 61 and flows toward the one end 61a of the cooling air flow path 61. The cooling air changes its flow direction from the one end 61a of the cooling air flow path 61 to the one end 21a of the cooling air flow path 21. The cooling air flows from the one end 21a of the cooling air flow path 21 to the other end 21b of the cooling air flow path 21 and is drawn into the blower 53.

In such a flow of cooling air, in the example of FIG. 8(a), as indicated by the thick dashed line, in all of the main circuit modules 10X to 10Z, the first air-cooling fin 32 is disposed in the cooling air flow path 21 and the second air-cooling fin 35 is disposed in the cooling air flow path 61. Therefore, the order of cooling, from the upstream side of the cooling air, is the second air-cooling fin 35 of the main circuit module 10Z, the second air-cooling fin 35 of the main circuit module 10Y, the second air-cooling fin 35 of the main circuit module 10X, the first air-cooling fin 32 of the main circuit module 10X, the first air-cooling fin 32 of the main circuit module 10Y, and the first air-cooling fin 32 of the main circuit module 10Z. The functional elements 40 included in the main circuit modules 10X to 10Z may be selected taking into account this order of cooling and the heat generation amount of the functional elements 40.

On the other hand, in the example of FIG. 8(b), as indicated by the thick dashed line, in all of the main circuit modules 10S to 10U, the first air-cooling fin 32 is disposed in the cooling air flow path 21, but the second air-cooling fin 35 is disposed in the cooling air flow path 61 only in the main circuit module 10T. The main circuit module 10T includes the power circuit element 46. In this manner, taking into account the order of cooling and the heat generation amount of the functional elements 40, the second air-cooling fin 35 of the main circuit module 10T including the functional element 40 having a large heat generation amount may be disposed in the cooling air flow path 61, and the second air-cooling fins 35 of the main circuit modules 10S and 10U including the functional elements 40 having a small heat generation amount may be omitted. That is, the main circuit modules 10S to 10U include first modules 10S and 10U in which the functional element is a capacitor or a filter coil, and a second module 10T in which the functional element is a power circuit element 46 (power module) having a heat generation amount larger than that of the first modules 10S and 10U. In the first modules 10S and 10U, the first air-cooling fin 32 is housed in the cooling air flow path 21. In the second module 10T, the first air-cooling fin 32 is housed in the cooling air flow path 21, and the second air-cooling fin 35 is housed in the cooling air flow path 61. It should be noted that, in the first modules 10S and 10U, instead of only the first air-cooling fin 32 being housed in the cooling air flow path 21, only the second air-cooling fin 35 may be housed in the cooling air flow path 61.

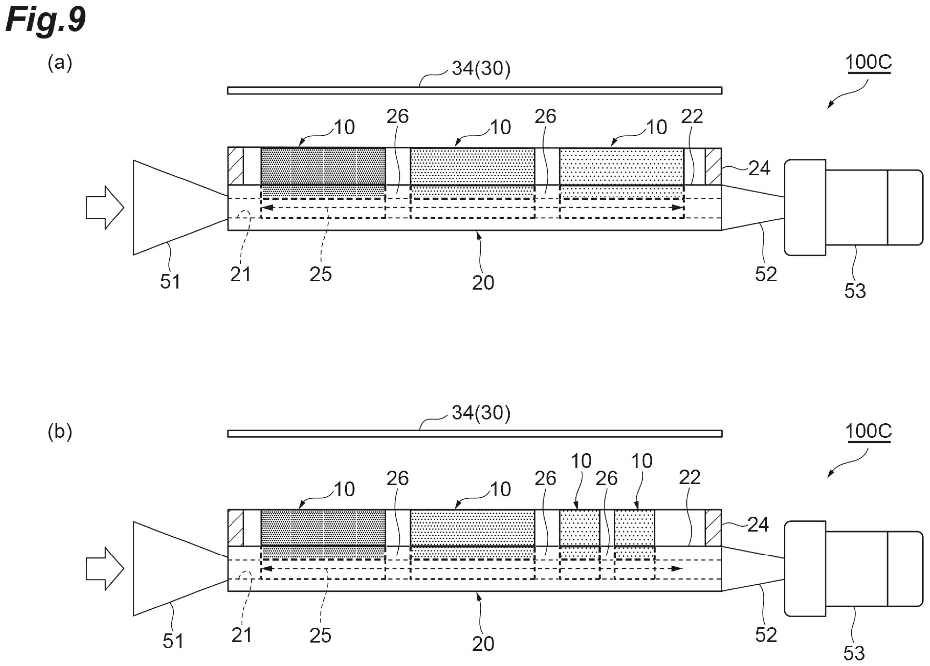

FIG. 9(a) is a side view illustrating an example of a schematic configuration of a fourth example of a cooling structure for a main circuit module. FIG. 9(b) is a side view illustrating a variation of the schematic configuration of the fourth example of the cooling structure for a main circuit module. A cooling structure 100C for a main circuit module according to the fourth example differs from the cooling structures 100, 100A, and 100B for a main circuit module according to the first to third examples, in which the module holes 23 were discontinuous between adjacent main circuit modules 10, in that the module hole 25 is continuous between adjacent main circuit modules 10.

As illustrated in FIG. 9(a), when the module hole 25 is continuous for the plurality of main circuit modules 10, the module hole 25 may open in a shape surrounding all of the plurality of main circuit modules 10 as viewed in the normal direction of the mounting surface 22. In the example of FIG. 9(a), the module hole 25 is provided so as to form a substantially rectangular parallelepiped space having a constant width in the direction intersecting the extending direction of the cooling air flow path 21 and having the longitudinal direction along the extending direction of the cooling air flow path 21. In the example of FIG. 9(a), a lid member serving as a spacer 26 is disposed in the module hole 25 between adjacent main circuit modules 10. The empty portion of the module hole 25 can be filled with the spacer 26 according to the size of the main circuit module 10.

In the example of FIG. 9(b), one of the main circuit modules 10 of FIG. 9(a) is separated into two. Even in this case, by using the corresponding spacer 26, the module hole 25 and the base part 20 can be used in common. It should be noted that all of the main circuit modules 10 may be placed adjacent to each other without using the spacer 26.

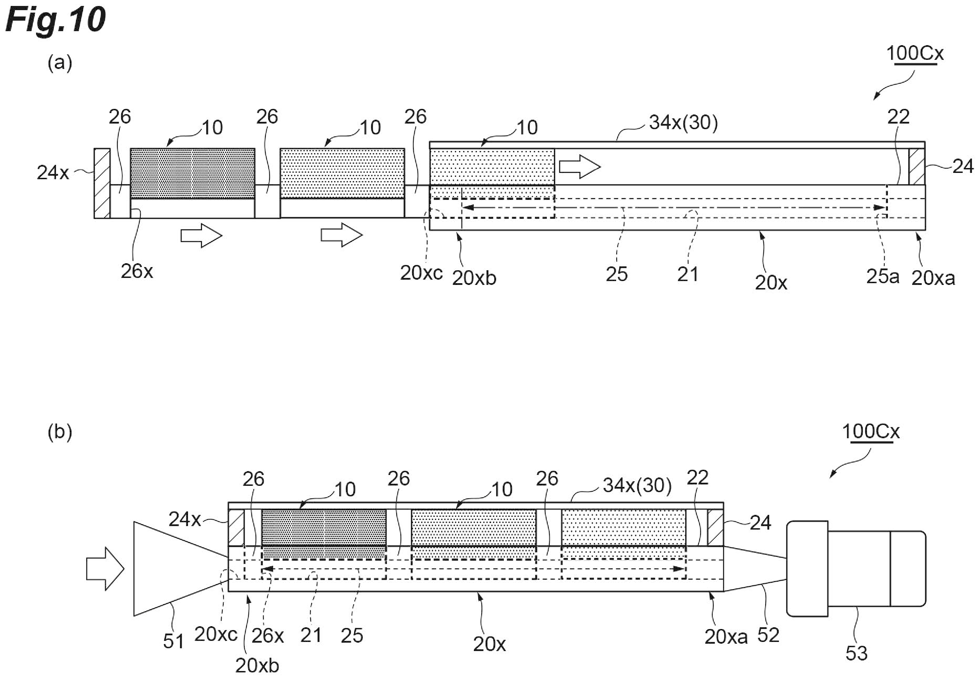

FIG. 10(a) is a partially exploded side view illustrating an example of a schematic configuration of a variation of the fourth example of FIG. 9(a). FIG. 10(b) is a side view illustrating an example of the schematic configuration of the variation of the fourth example of FIG. 9(a). A cooling structure 100Cx for a main circuit module according to the variation of the fourth example differs from the cooling structure 100C for a main circuit module and the like, in which the main circuit module 10 is attached to the base part 20 by being inserted along a direction orthogonal to the extending direction of the cooling air flow path 21, in that the main circuit module 10 is attached to a base part 20x by being slid along the extending direction of the cooling air flow path 21.

In the example of FIG. 10(a), the right end 20xa of the base part 20x on the paper is the same as in the example of FIG. 9(a), but the left end 20xb of the base part 20x on the paper differs from the configuration of FIG. 9(a). The base part 20x has an opening 20xc that is continuous with the module hole 25 and opens to the end 20xb. The main circuit module 10 can be inserted into and removed from the module hole 25 via the opening 20xc.

The base part 20x may be provided with a guide part that slidably supports the main circuit module 10 along the extending direction of the cooling air flow path 21. The guide part may be provided over the entire area from the opening 20xc at the end 20xb to the right end 25a of the module hole 25 on the paper. As the guide part, a known guide structure can be used, such as, for example, a pair of rails provided on both sides of the module hole 25, or a ridge and a groove formed correspondingly on the side surfaces of the main circuit module 10 and the spacer 26. The rails of the guide part may be provided on the main circuit module 10 and the spacer 26.

The spacer 26 located on the end 20xb side of the base part 20x may be slidably supported by the guide part in the same manner as the main circuit module 10. A side wall part 24x adjacent to this spacer 26 may be a member separate from the base part 20x and attached to the opening 20xc in order to close the opening 20xc. The side wall part 24x may be a separate member corresponding to one plate on the left side of the paper out of the rectangular frame body of the above-described side wall part 24.

When sliding the main circuit module 10 to attach it to the base part 20x, the cover member 34x may be in a state of being attached to the tip of the side wall part 24. When all of the main circuit modules 10 are slid and attached to the base part 20x, and the opening 20xc of the base part 20x is closed by the spacer 26 and the side wall part 24x, the cooling structure 100Cx for a main circuit module is configured in substantially the same manner as the cooling structure 100C for a main circuit module, as in the example of FIG. 10(b). At this time, the right surface 26x of the spacer 26 that has closed the opening 20xc on the paper becomes the left end of the module hole 25 on the paper. It should be noted that, since the plurality of main circuit modules 10 and the spacers 26 can slide along the guide part, their installation positions can be adjusted on the module hole 25.

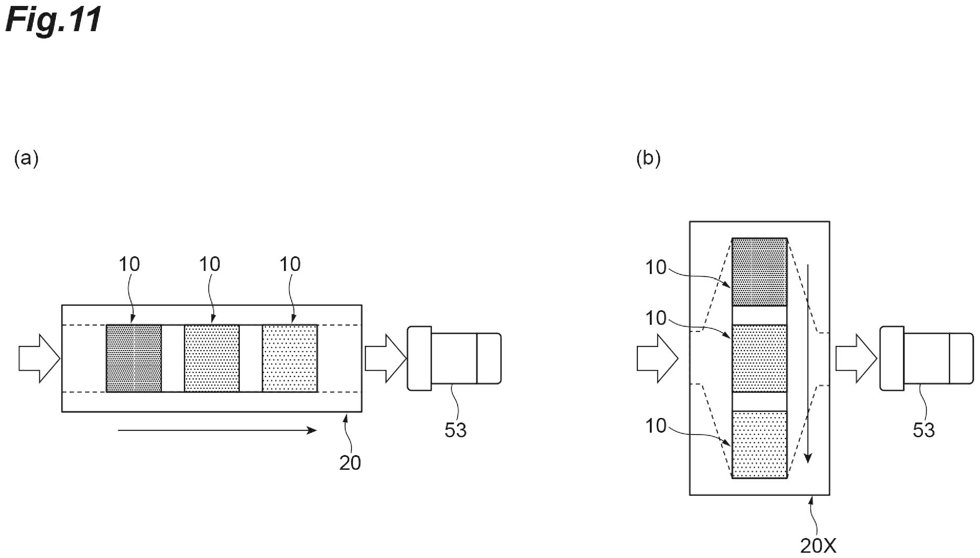

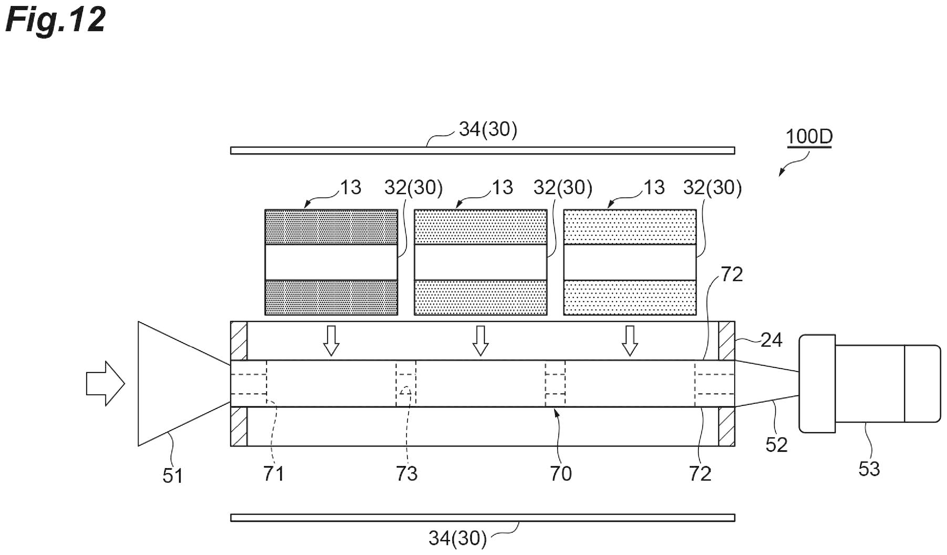

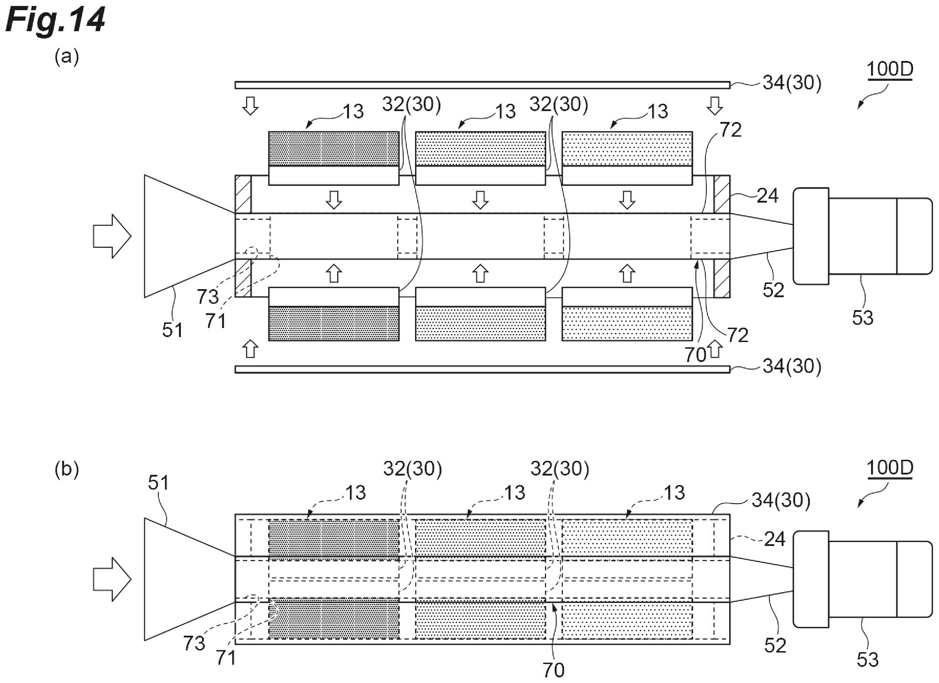

FIGS. 11(a) and 11(b) are plan views illustrating examples of arrangements of main circuit modules. In FIGS. 1 to 9(b) described above and FIGS. 12, 14(a), and 14(b) described later, the arrangement direction of the main circuit modules 10 was along the flow direction of the cooling air, as illustrated in the base part 20 of FIG. 11(a). As illustrated in the base part 20X of FIG. 11(b), the arrangement direction of the main circuit modules 10 may be a direction intersecting (for example, orthogonal to) the flow direction of the cooling air. In this case, the space between adjacent main circuit modules 10 may be closed to prevent the cooling air from passing through.

FIG. 12 is an exploded side view illustrating an example of a schematic configuration of a fifth example of a cooling structure for a main circuit module. In the cooling structure 100D for a main circuit module of FIG. 12, the base part 70 differs from the base part 20 in that the module hole 71 is a through hole and the mounting surface 72 is provided on both front and rear surfaces. The base part 70 is configured such that when the main circuit module 13 is inserted into the module hole 71 formed in the base part 70, the first air-cooling fin 32 is disposed at a position where cooling air in the cooling air flow path 73 can flow therethrough.

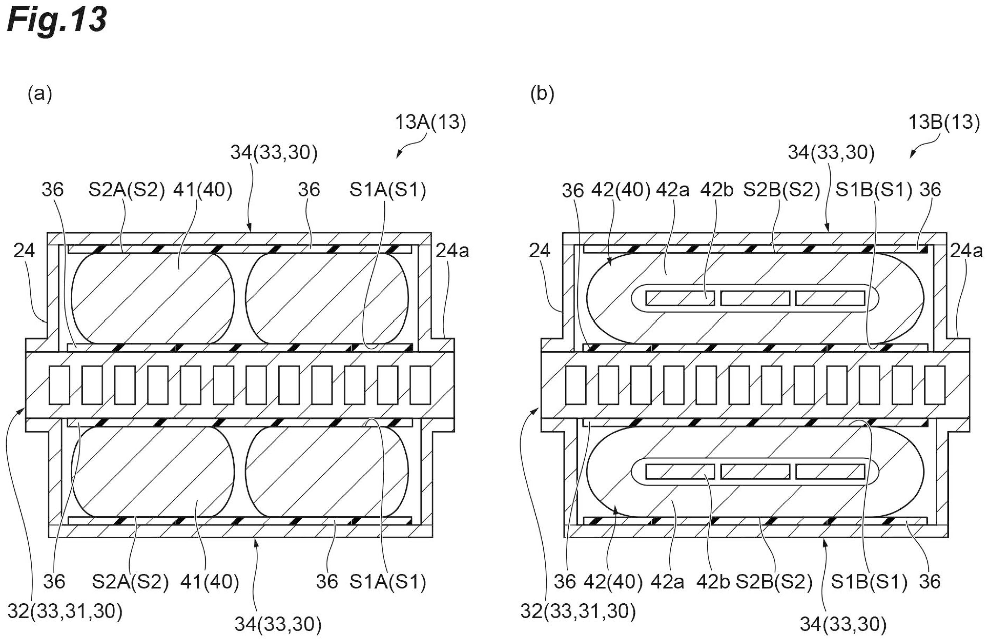

FIGS. 13(a) and 13(b) are schematic cross-sectional views illustrating examples of the main circuit module of FIG. 12. As illustrated in FIGS. 13(a) and 13(b), the main circuit module 13 may include a pair of functional elements 40 and a pair of second heat dissipation parts 33 provided on both sides of the first air-cooling fin 32 so as to sandwich the first air-cooling fin 32.

The main circuit module 13A of FIG. 13(a) corresponds to a configuration in which, in the main circuit module 13A in a case in which the functional element 40 is a capacitor 41 as in FIG. 2(a), additional capacitors 41 and the like are added on the opposite side so as to sandwich the first air-cooling fin 32. The main circuit module 13B of FIG. 13(b) corresponds to a configuration in which, in the main circuit module 10B in a case in which the functional element 40 is a filter coil 42 as in FIG. 2(b), an additional filter coil 42 and the like are added on the opposite side so as to sandwich the first air-cooling fin 32. In the main circuit modules 13A and 13B, similarly to the heat transfer path in the main circuit modules 10A and 10B, the heat of the functional element 40 is transferred on both sides of the first air-cooling fin 32 through the cover member 34 to the first air-cooling fin 32 as the second heat dissipation part 33.

FIG. 14(a) is an exploded side view illustrating an example of a variation of the schematic configuration of the fifth example of the cooling structure for a main circuit module. FIG. 14(b) is a schematic side view of the assembled state of FIG. 14(a). In FIGS. 13(a) and 13(b), the main circuit module 13A and 13B included a pair of functional elements 40 and a pair of second heat dissipation parts 33 provided on both sides of one common first air-cooling fin 32 so as to sandwich the first air-cooling fin 32, but the first air-cooling fins 32 may each be separate. As in the example of FIG. 14(a), the first air-cooling fin 32 may be divided into two equal parts so as to bisect the thickness dimension of the cooling air flow path 21. In this case, as illustrated in FIG. 14(b), the two equally divided first air-cooling fins 32 may be in contact with each other in a state in which the main circuit module 13 is attached to the base part 70.

As described above, in the cooling structures 100 to 100D for a main circuit module, not only the first heat dissipation part 31 on the one principal surface S1 side but also the second heat dissipation part 33 on the other principal surface S2 side is disposed on the functional elements 40 of the main circuit modules 10 and 13. The heat of the functional elements 40 is transferred to the first air-cooling fin 32 as the first heat dissipation part 31 and to the second air-cooling fin 35 as the second heat dissipation part 33, and the first air-cooling fin 32 is air-cooled by the cooling air in the cooling air flow path 21 while the second air-cooling fin 35 is air-cooled by the cooling air in the cooling air flow path 61. Alternatively, the heat of the functional elements 40 is transferred to the first air-cooling fin 32 as the first heat dissipation part 31 and as the second heat dissipation part 33, and the first air-cooling fin 32 is air-cooled by the cooling air in the cooling air flow path 21. In this manner, the functional elements 40 of the main circuit modules 10 and 13 attached to the base parts 20, 60, and 70 are efficiently air-cooled from the one principal surface S1 and the other principal surface S2. Therefore, it is possible to configure the functional elements 40 as the main circuit modules 10 and 13 and efficiently cool the functional elements 40 using an air cooling method.

The second heat dissipation part 33 is a cover member 34 that is in thermal contact with the other principal surface S2 of the functional element 40 and is thermally coupled to the first heat dissipation part 31. According to this configuration, the functional element 40 can be air-cooled from the other principal surface S2 via the cover member 34.

The cooling air flow path 21 and the cooling air flow path 61 are parallel to each other. According to this configuration, it becomes easier to dispose the first air-cooling fin 32 on the one principal surface S1 side of the functional element 40 and the second air-cooling fin 35 on the other principal surface S2 side of the functional element 40, compared to a case in which the cooling air flow path 21 and the cooling air flow path 61 are not parallel.

One end 21a of the cooling air flow path 21 and one end 61a of the cooling air flow path 61 are connected such that the flow direction of the cooling air in the cooling air flow path 21 and the flow direction of the cooling air in the cooling air flow path 61 are opposite to each other. According to this configuration, the inlet and outlet of the cooling air can be disposed on the same end side of the cooling air flow path 21 and the cooling air flow path 61.

The main circuit modules 10S to 10U include the first modules 10S and 10U in which the functional element is a capacitor or a filter coil, and the second module 10T in which the functional element is a power circuit element 46 (power module) having a heat generation amount larger than that of the first modules. In the first modules 10S and 10U, the first air-cooling fin 32 is housed in the cooling air flow path 21. In the second module 10T, the first air-cooling fin 32 is housed in the cooling air flow path 21, and the second air-cooling fin 35 is housed in the cooling air flow path 61. According to this configuration, since the second module 10T, which has a larger heat generation amount than the first modules 10S and 10U, is cooled by both the first air-cooling fin 32 and the second air-cooling fin 35, the second module 10T can be cooled efficiently.

The second heat dissipation part 33 includes the second air-cooling fin 35 housed in the cooling air flow path 61 of the base part 60 different from the cooling air flow path 21, and an auxiliary member 47 that is in thermal contact with the functional element 40 or the first air-cooling fin 32 and is thermally coupled to the second air-cooling fin 35. According to this configuration, the auxiliary member 47, which is in thermal contact with the functional element 40 or the first air-cooling fin 32 and is thermally coupled to the second air-cooling fin 35, can constitute a heat transfer path to the second air-cooling fin 35.

The main circuit module 13 includes the functional elements 40 and the second heat dissipation parts 33, both provided on each side of the first heat dissipation part 31 so as to sandwich the first heat dissipation part 31. According to this configuration, two functional elements 40 and two second heat dissipation parts 33 can be efficiently arranged.

The main circuit modules 10 and 13 are detachably attached in a state of being inserted into the module holes 23, 25, and 71 formed in the base parts 20, 60, and 70. According to this configuration, replacement or specification change of the main circuit module with respect to one base part becomes easy.

### [Variations]

The examples of the semiconductor module of the present disclosure have been described above. The semiconductor module of the present disclosure may be implemented in various forms without being limited to the above examples.

In the embodiments, a base plate having a rectangular parallelepiped external appearance was exemplified as the base parts 20, 60, and 70, but the present disclosure is not limited to this example. Various shapes and materials can be selected as long as the configuration such as the cooling air flow path can be formed and the main circuit module can be attached.

The first air-cooling fin 32 was exemplified as the first heat dissipation part 31, and the second air-cooling fin 35 was exemplified as the second heat dissipation part 33, but the present disclosure is not limited to these examples. Other configurations can be used as long as they are air-cooling configurations that function as a heat dissipation part thermally coupled to the functional element.

It should be noted that the constituent elements of various aspects of the present disclosure are described below.
[1] A cooling structure for a main circuit module, comprising:
   A main circuit module having a functional element and a heat dissipation part thermally coupled to the functional element, and
   a base part to which the main circuit module is attached,
   wherein the heat dissipation part has a first heat dissipation part disposed on one principal surface side of the functional element and a second heat dissipation part disposed on an other principal surface side different from the one principal surface of the functional element,
   wherein in a state in which the main circuit module is attached to the base part,
      the first heat dissipation part is a first air-cooling fin housed in a first cooling air flow path of the base part, and
      the second heat dissipation part is a second air-cooling fin housed in a second cooling air flow path of the base part different from the first cooling air flow path, or a member that is in thermal contact with the other principal surface of the functional element and is thermally coupled to the first heat dissipation part.
[2] The cooling structure for a main circuit module according to [1],
   wherein the second heat dissipation part is a cover member that is in thermal contact with the other principal surface of the functional element and is thermally coupled to the first heat dissipation part.
[3] The cooling structure for a main circuit module according to [1],
   wherein the first cooling air flow path and the second cooling air flow path are parallel to each other.
[4] The cooling structure for a main circuit module according to [3],
   wherein one end of the first cooling air flow path and one end of the second cooling air flow path are connected such that a flow direction of cooling air in the first cooling air flow path and a flow direction of cooling air in the second cooling air flow path are opposite to each other.
[5] The cooling structure for a main circuit module according to [3] or [4],
   wherein the main circuit module includes a first module in which the functional element is a capacitor or a filter coil, and a second module in which the functional element is a power module having a heat generation amount larger than that of the first module,
   wherein in the first module, the first air-cooling fin is housed in the first cooling air flow path, or the second air-cooling fin is housed in the second cooling air flow path, and
   wherein in the second module, the first air-cooling fin is housed in the first cooling air flow path, and the second air-cooling fin is housed in the second cooling air flow path.
[6] The cooling structure for a main circuit module according to any one of [3] to [5],
   wherein the second heat dissipation part includes the second air-cooling fin housed in the second cooling air flow path of the base part different from the first cooling air flow path, and an auxiliary member that is in thermal contact with the functional element or the first air-cooling fin and is thermally coupled to the second air-cooling fin.
[7] The cooling structure for a main circuit module according to any one of [1] to [6],
   wherein the main circuit module includes a pair of the functional elements and a pair of the second heat dissipation parts provided on both sides of the first heat dissipation part so as to sandwich the first heat dissipation part.
[8] The cooling structure for a main circuit module according to any one of [1] to [7],
   wherein the main circuit module is detachably attached in a state of being inserted into a module hole formed in the base part.

### Reference Signs List

10, 10A, 10B, 10C, 10D, 10E, 10F, 10X, 10Y, 10Z, 13, 13A, 13B Main circuit module
10S, 10U Main circuit module (first module)
10T Main circuit module (second module)
S1, S1A, S1B, S1C, S1D, S1E, S1F One principal surface
S2, S2A, S2B, S2C, S2D, S2E Other principal surface
20, 20x, 60, 70 Base part
21a, 61a One end
21 Cooling air flow path (first cooling air flow path)
23, 25, 63, 71 Module hole
24 Side wall part (member)
30 Heat dissipation part
31 First heat dissipation part
32 First air-cooling fin (first heat dissipation part)
33 Second heat dissipation part
34, 34x Cover member (member, second heat dissipation part)
35 Second air-cooling fin (second heat dissipation part)
40 Functional element
41 Capacitor
42 Filter coil
46 Power circuit element (power module)
47 Auxiliary member
61 Cooling air flow path (second cooling air flow path)
100, 100A, 100B, 100C, 100Cx, 100D Cooling structure for main circuit module

## Claims

1. A cooling structure for a main circuit module, comprising:
a main circuit module having a functional element and a heat dissipation part thermally coupled to the functional element; and
a base part to which the main circuit module is attached,
wherein the heat dissipation part has a first heat dissipation part disposed on one principal surface side of the functional element and a second heat dissipation part disposed on an other principal surface side different from the one principal surface of the functional element,
wherein in a state in which the main circuit module is attached to the base part,
the first heat dissipation part is a first air-cooling fin housed in a first cooling air flow path of the base part, and
the second heat dissipation part is a second air-cooling fin housed in a second cooling air flow path of the base part different from the first cooling air flow path, or a member that is in thermal contact with the other principal surface of the functional element and is thermally coupled to the first heat dissipation part.

2. The cooling structure for a main circuit module according to claim 1,
wherein the second heat dissipation part is a cover member that is in thermal contact with the other principal surface of the functional element and is thermally coupled to the first heat dissipation part.

3. The cooling structure for a main circuit module according to claim 1,
wherein the first cooling air flow path and the second cooling air flow path are parallel to each other.

4. The cooling structure for a main circuit module according to claim 3,
wherein one end of the first cooling air flow path and one end of the second cooling air flow path are connected such that a flow direction of cooling air in the first cooling air flow path and a flow direction of cooling air in the second cooling air flow path are opposite to each other.

5. The cooling structure for a main circuit module according to claim 3 or 4,
wherein the main circuit module includes a first module in which the functional element is a capacitor or a filter coil, and a second module in which the functional element is a power module having a heat generation amount larger than that of the first module,
wherein in the first module, the first air-cooling fin is housed in the first cooling air flow path, or the second air-cooling fin is housed in the second cooling air flow path, and
wherein in the second module, the first air-cooling fin is housed in the first cooling air flow path, and the second air-cooling fin is housed in the second cooling air flow path.

6. The cooling structure for a main circuit module according to claim 3 or 4,
wherein the second heat dissipation part includes the second air-cooling fin housed in the second cooling air flow path of the base part different from the first cooling air flow path, and an auxiliary member that is in thermal contact with the functional element or the first air-cooling fin and is thermally coupled to the second air-cooling fin.

7. The cooling structure for a main circuit module according to claim 1 or 2,
wherein the main circuit module includes a pair of the functional elements and a pair of the second heat dissipation parts provided on both sides of the first heat dissipation part so as to sandwich the first heat dissipation part.

8. The cooling structure for a main circuit module according to claim 1 or 2,
wherein the main circuit module is detachably attached in a state of being inserted into a module hole formed in the base part.
